# EUROPEAN PATENT APPLICATION

(11) **EP 1 801 578 A1**
(43) Date of publication of application: **27.06.2007**
(21) Application number: 05782028.4
(22) Date of filing: 09.09.2005
(51) Int. Cl.: G01N 29/12

(54) **MICROSTRUCTURE INSPECTING APPARATUS AND MICROSTRUCTURE INSPECTING METHOD**

(30) Priority: 13.09.2004 JP 2004265385
(71) Applicant: OCTEC INC., Tokyo 160-0011 (JP); TOKYO ELECTRON LIMITED, Minato-ku, Tokyo 107-8481 (JP)
(72) Inventor: YAKABE, Masami, c/o TOKYO ELECTRON AT LTD, Amagasaki City, Hyogo 660-0891 (JP); MATSUMOTO, Toshiyuki, c/o TOKYO ELECTRON AT LTD, Amagasaki City, Hyogo 660-0891 (JP); IKEUCHI, Naoki, c/o TOKYO ELECTRON AT LIMITED, Amagasaki City, Hyogo 660-0891 (JP); OKUMURA, Katsuya, Shinjuku-ku, Tokyo 1600011 (JP)
(74) Representative: Liesegang, Eva
(86) International application number: PCT/JP2005/016663
(87) International publication number: WO 2006/030716

(57) **Abstract**

Voltage is applied to a chip TP by a voltage drive unit 30 through a probe needle P to move a movable part of a microstructure. A sound produced in response to motion of the movable part of the microstructure is detected by a microphone 3. Then, the sound detected by the microphone 3 is measured by a measurement unit 25. The control unit 20 evaluates the characteristics of the tested chip TP by comparing with a sound detected from an ideal chip TP.

## Description

### BACKGROUND OF THE INVENTION

### 1. Field of the Invention

The present invention relates to an inspection apparatus and method for testing microstructures such as MEMS (Micro Electro Mechanical Systems).

### 2. Description of Related Art

MEMS, which are devices in which various functions such as mechanical, electronic, optical and chemical functions are integrated particularly using semiconductor microfabrication technology or the like, have received great attention in recent years. A practical example adopting the MEMS technology so far is microsensors including acceleration sensors, pressure sensors, air flow sensors and so on used as various types of sensors for automobiles and medical purposes, and the MEMS devices are mounted on such microsensors.

The adoption of the MEMS technology in an inkjet printer head enables an increase in the number of nozzles for ejecting ink and precisely controlled ejection of the ink, thereby making it possible to improve image quality and printing speed. In addition, a micromirror array used in reflective projectors is also known as a general MEMS device. Further, future development of various sensors and actuators utilizing the MEMS technology is expected to be broadly applied to optical communications and mobile apparatuses, computing machines and their peripheral devices, bio-analysis, and power sources for portable apparatuses. A variety of MEMS technologies are introduced in Technology Research Report Vol. 3 (issued by the Technology Research and Information Office in the Industrial Science and Technology Policy and Environment Bureau, and the Industrial Machinery Division in the Manufacturing Industries Bureau of the Ministry of Economy, Trade and Industry, on March 28th, 2003) under the agenda of the current state of the art and problems encompassing MEMS.

Meanwhile, with the development of the MEMS devices, systems for appropriately inspecting the MEMS devices are of increasing importance. For example, a structure having microscopic movable parts, such as an acceleration sensor, is a device whose response characteristics change with a microscopic movement and therefore needs to be inspected with high precision to evaluate the characteristics.

One example in the inspection methods includes: previously forming a test pad to evaluate the characteristics of the device; detecting the output characteristics from the test pad according to a predetermined test pattern; and analyzing the output characteristics to evaluate the device characteristics. Alternatively, a laser displacement meter or the like is conceivably used to detect the amount of displacement of the microscopic movable parts of the microstructures in order to evaluate the device characteristics.

It is assumed to use a free pad that is not used as a test pad among the pads generally prepared on the device in advance. It is becoming increasingly difficult to use the free pad, however, with an increase of function performed by the recent devices because the number of pads is limited under the layout constraints and so on.

It might be possible to additionally form a special pad intended for test use only, however such a pad would cause the area of the chip to increase and therefore to increase the manufacturing cost.

The laser displacement meter or the like, which evaluates the device characteristics based on the measurement value responded to irradiation of laser light, is not applicable to the area of the device where the laser light cannot reach.

Furthermore, it is significantly difficult for the device to undergo nondestructive inspection to check its possible internal destruction and external destruction that cannot be readily found by visual inspection. Even though the nondestructive inspection may be executed, such an inspection requires a highly expensive tester.

### BRIEF SUMMARY OF THE INVENTION

The present invention is made to solve the above-described problems and has an object to provide a microstructure inspection apparatus and microstructure inspection method for readily testing structures with microscopic movable parts with high precision.

The microstructure inspection apparatus according to the present invention is to evaluate the characteristics of a microstructure with a movable part and includes electric drive means for providing motion to the movable part of the microstructure and characteristic evaluation means for detecting a sound produced by the motion of the movable part of the microstructure provided by the drive means and for evaluating the characteristics of the microstructure based on the detection results.

A plurality of microstructures are arranged in an array form on a base, for example.

The above-described characteristic evaluation means preferably includes measurement means for detecting a sound produced in response to the motion of the movable part of the microstructure and determination means for evaluating the characteristics of the microstructure based on a comparison between the signal characteristics of the sound detected by the measurement means and the signal characteristics of a sound serving as a predetermined threshold.

In one embodiment, the measurement means detects the frequency characteristics of sounds, while the determination means evaluates the characteristics of the microstructure by comparing the frequency characteristics of a sound detected by the measurement means and the frequency characteristics of a sound serving as a predetermined threshold.

In another embodiment, the measurement means detects the amplitude of sounds, while the determination means evaluates the characteristics of the microstructure by comparing the amplitude of a sound detected by the measurement means and the amplitude of a sound serving as a predetermined threshold.

In yet another embodiment, the measurement means detects the phase characteristics of sounds, while the determination means evaluates the characteristics of the microstructure by comparing the phase characteristics of a sound detected by the measurement means and the phase characteristics of a sound serving as a predetermined threshold.

The microstructure is at least one device selected from the group consisting of, for example, a switch, an acceleration sensor, an angular velocity sensor, a pressure sensor and a microphone. The acceleration sensor is, for example, a multiaxial acceleration sensor, while the angular velocity sensor is, for example, a multiaxial angular velocity sensor.

A microstructure inspection method according to the present invention includes the steps of providing motion to a movable part of a microstructure by using electric means, detecting a sound produced by the motion of the movable part of the microstructure, and evaluating the characteristics of the microstructure based on the detection results of the sound.

The above-described characteristic evaluation step preferably includes a step of performing comparison between the signal characteristics of the detected sound and the signal characteristics of a sound serving as a predetermined threshold.

In one embodiment, the sound detection step includes detection of the frequency characteristics of sounds, while the characteristic evaluation step includes a step of performing comparison between the frequency characteristics of the detected sound and the frequency characteristics of a sound serving as a predetermined threshold.

In another embodiment, the sound detection step includes a step of performing detection of the amplitude of sounds, while the characteristic evaluation step includes a comparison between the amplitude of the detected sound and the amplitude of a sound serving as a predetermined threshold.

In yet another embodiment, the sound detection step includes a step of performing detection of the phase characteristics of sounds, while the characteristic evaluation step includes a step of performing comparison between the phase characteristics of the detected sound and the phase characteristics of a sound serving as a predetermined threshold.

The microstructure inspection apparatus and microstructure inspection method according to the present invention detects a sound produced by the motion of the movable part of the microstructure and evaluates the characteristics of the microstructure based on the detection results. Thus, there is no need to provide a special test pad intended for inspection use only, and therefore a simple test can be achieved. In addition, nondestructive inspections to check a device's possible internal destruction and external destruction that cannot be readily found by visual inspection can be realized.

### BRIEF DESCRIPTION OF THE DRAWINGS

FIG. 1 is a schematic block diagram of a microstructure inspection system according to an embodiment the present invention.
FIG. 2A is a conceptual diagram for schematically illustrating a cantilever-type MEMS switch at rest.
FIG. 2B is a conceptual diagram for schematically illustrating the cantilever-type MEMS switch in operation.
FIG. 3 is a flow chart illustrating a method for inspecting microstructures according to the embodiment of the invention.
FIG. 4 illustrates a membrane structure used in an irradiation window of an electron beam irradiator.
FIG. 5 is a conceptual diagram partially illustrating a microstructure inspection system according to the embodiment of the invention.
FIG. 6 illustrates a detailed description of a measurement jig 45 and the irradiation window 80 of the electron beam irradiator mounted thereon.
FIG. 7 is another illustration to describe in detail the measurement jig 45 and the irradiation window 80 of the electron beam irradiator mounted thereon.
FIG. 8 is an overhead view of a device of a triaxial acceleration sensor.
FIG. 9 is a schematic diagram of the triaxial acceleration sensor.
FIG. 10 is a conceptual diagram illustrating masses and deformation of beams in the case where acceleration is applied in the direction of each axis.
FIG. 11A is a circuit configuration diagram of Wheatstone bridge for the X axis (Y axis).
FIG. 11B is a circuit configuration diagram of Wheatstone bridge for the Z axis.
FIG. 12A is a graph illustrating an output response relative to an inclination angle of the triaxial acceleration sensor and showing data when the sensor is rotated about the X axis.
FIG. 12B is a graph illustrating an output response relative to an inclination angle of the triaxial acceleration sensor and showing data when the sensor is rotated about the Y axis.
FIG. 12C is a graph illustrating an output response relative to an inclination angle of the triaxial acceleration sensor and showing data when the sensor is rotated about the Z axis.
FIG. 13 is a graph illustrating the relationship between the gravitational acceleration (input) and output of the sensor.
FIG. 14A is a graph illustrating the frequency characteristics of the triaxial acceleration sensor, i.e. frequency characteristics output from the X axis of the sensor.
FIG. 14B is a graph illustrating the frequency characteristics of the triaxial acceleration sensor, i.e. frequency characteristics output from the Y axis of the sensor.
FIG. 14C is a graph illustrating the frequency characteristics of the triaxial acceleration sensor, i.e. frequency characteristics output from the Z axis of the sensor.
FIG. 15 illustrates the device of the triaxial acceleration sensor provided with a measurement jig thereunder.
FIG. 16A is a schematic view of electrodes embedded in the measurement jig as viewed from the side of the device in the test of the triaxial acceleration sensor.
FIG. 16B is a schematic view of a chip of the triaxial acceleration sensor mounted on the measurement jig as viewed from the side of the device in the test of the triaxial acceleration sensor.
FIG. 16C is a schematic view of the motion of the triaxial acceleration sensor with a voltage applied as viewed from the side of the device in the test of the triaxial acceleration sensor.
FIG. 17 illustrates the device of the triaxial acceleration sensor provided with another measurement jig thereunder.

### DESCRIPTION OF THE PREFERRED EMBODIMENTS

Embodiments of the present invention will now be described in detail with reference to the accompanying drawings. It should be noted that the same elements or equivalents are denoted with the same reference numerals and their descriptions are not reiterated.

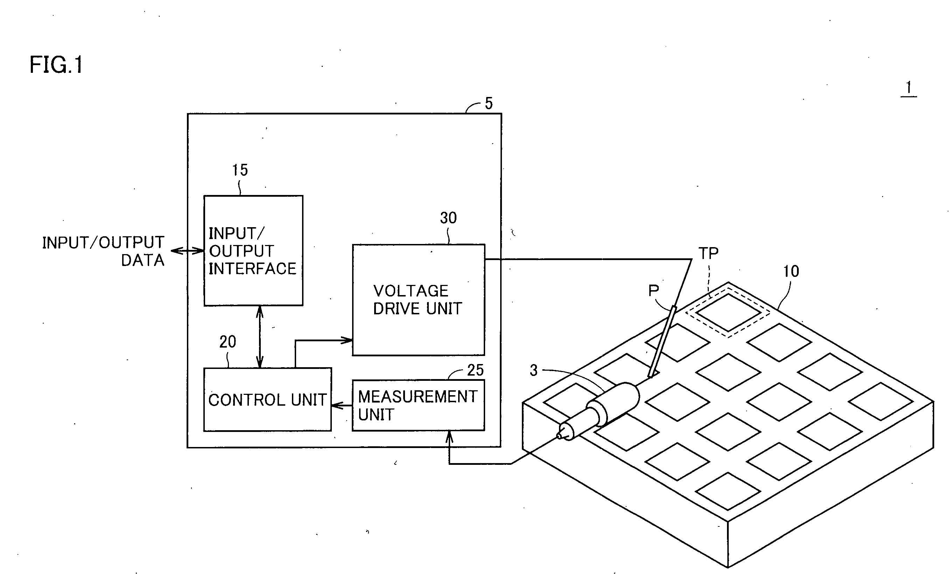

FIG. 1 is a schematic block diagram of a microstructure inspection system 1 according to an embodiment the present invention.

Referring to FIG. 1, the inspection system 1 according to the embodiment of the invention includes a tester (inspection apparatus) 5 and a base 10 on which a plurality of microstructured chips TP each having a microscopic movable part are formed.

The tester 5 is provided with a microphone 3 for detecting sounds output from the chip TP to be tested, an input/output interface 15 for transmitting and receiving input/output data between the outside and the inside of the tester, a control unit 20 for controlling the entire tester 5 and analyzing sounds detected by a measurement unit 25, the measurement unit 25 for measuring the sound detected by the microphone 3, a voltage drive unit 30 for outputting a voltage which is an electrical signal to provide motion to the movable part of the chip TP. The microphone 3 shall be arranged in the vicinity of a test object. In FIG. 1, a predetermined voltage shall be applied from the voltage drive unit 30 through a probe needle P to a pad (not shown) on the chip TP. The description is made for the case where the movable part of the chip TP is moved by electric action in this embodiment, but not limited to this, and the movable part of the chip TP can be moved by other means, for example, magnetic action.

In this embodiment, a description will be made in the case where a test is executed with a cantilever-type MEMS switch (hereinafter, referred to as just "switch") as an example.

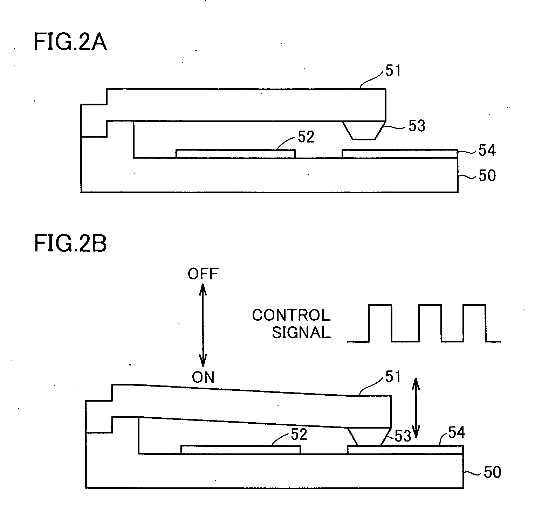

FIG. 2A is a conceptual diagram to briefly describe the cantilever-type MEMS switch at rest. The switch includes a substrate 50, a cantilever 51, a control electrode 52, a cantilever contact portion 53, and a contact electrode 54.

FIG. 2B illustrates the switch in operation. When a control signal is applied to the control electrode 52, the cantilever 51 is attracted toward the control electrode 52. Then, the cantilever contact portion 53 comes into contact with the contact electrode 54, which brings the switch to an ON state. For example, when a pulsed control signal set at "H" level or "L" level is applied to the control electrode 52, the cantilever contact portion 53 moves up and down to repeatedly enter a contact state and noncontact state with the contact electrode 54. The control signal set at "L" brings the switch into the state shown in FIG. 2A, while the control signal set at "H" level brings the switch into the state shown in FIG. 2B.

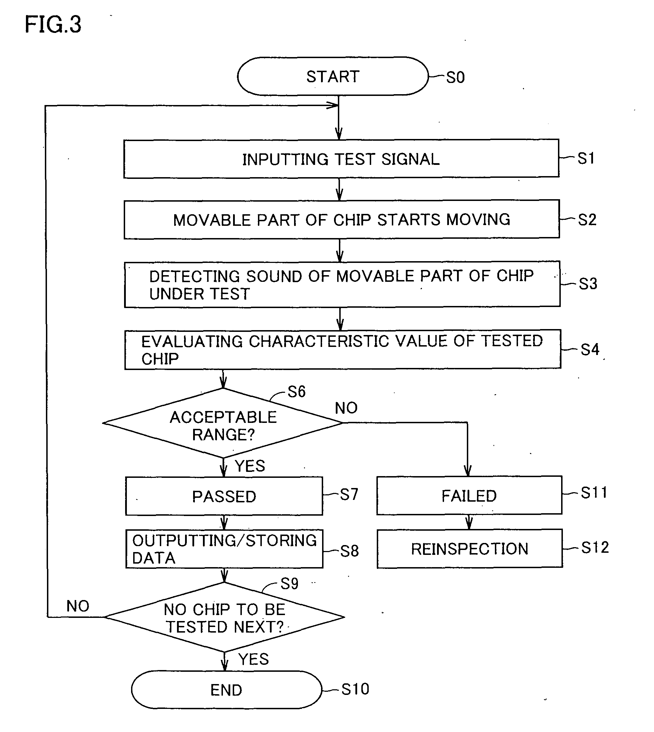

With the use of the flow chart of FIG. 3, a description will be made about the microstructure inspection method according to the embodiment of the invention. Referring to FIG. 3, at first, the inspection (test) of a microstructure is initiated (started) (step S0). Next, a test signal is input to the chip TP to be tested (step S1). Specifically, when a probe needle P makes contact with a certain pad PD as shown in FIG. 1, a predetermined pulsed output voltage, which is a test signal, is applied from the voltage drive unit 30 to the control electrode 52. The test signal is input, based on the input/output data input from the outside, through the input/output interface 15 to the control unit 20 that then controls the voltage drive unit 30 so as to output a predetermined output voltage as a test signal.

The application of the test signal effects the operation of the movable part of the chip TP under test (step S2). Specifically, as illustrated in FIG. 2, the switch goes into action with the test signal applied to the control electrode 52, and the cantilever contact portion 53 enters the contact state with the contact electrode 54. Then, the microphone 3 detects the contact sound (impact sound) produced by this contact. In other words, a sound of the cantilever contact portion 53, which is a movable part of the chip under the test, is detected (step S3).

Next, the control unit 20 evaluates the characteristic value of the tested chip based on the sound detected by the microphone 3 (step S4).

Next, the control unit 20 determines whether the measured characteristic value, that is measured data, is within an acceptable range (step S6).

Specifically, the signal characteristics of the sound detected by the measurement unit 25 are compared with predetermined threshold signal characteristics and then evaluated based on the comparison result. Subsequently, it is determined from the comparison result whether the characteristic value of the detected sound are in the acceptable range. There may be various schemes to compare the signal characteristics of the detected sound. One of the examples is to compare with an ideal sound detected from an ideal chip as a reference sound. The sound pressure, spectrum, frequency characteristic, amplitude, phase characteristic or the like of the reference sound is defined as a reference, that is, a threshold, and is compared to make it possible to evaluate the detected sound of the chip. For instance, if the sound detected from the chip under the test shows quite different frequency characteristics after the comparison with the frequency characteristics of the reference sound, it can be determined that the tested chip is defective. Alternatively, by comparing the amplitude of the detected sound and the amplitude of the reference sound, the characteristics of the tested chip can be evaluated. Additionally, the comparison between the phase of the detected sound and the phase of the reference sound can evaluate the characteristics of the tested chip. It is also possible to compare with a combination of these factors to evaluate the characteristics of the tested chip.

When the characteristic value of the detected sound is determined to be within the acceptable range in step S6, it is recognized that the detected chip passed the test (step S7), and then it is output as data and stored (step S8). The storage of the data is not illustrated, however, the data shall be stored in a storage unit like a memory provided in the tester 5 under the direction from the control unit 20. The control unit 20 also serves as a determination unit to determine the chip under the test based on the measured data from the measurement unit 25.

When it is found that there is no chip to be tested in step S9, the inspection (test) of the microstructure is terminated (step S10). On the other hand, when it is found that there is another chip to be tested in step S9, the procedure returns to the first step S1 to execute the next inspection.

If the control unit 20 determines that the evaluated characteristic value, that is measured data, is not within the acceptable range in step S6, it is recognized that the chip failed the test (step S11), and then reinspection is executed (step S12). Specifically, chips that are determined to be not within the acceptable range after reinspection can be removed. Alternatively, even such chips without an acceptable range can be classified into a plurality of groups. Actually, there possibly exist many chips that could not meet the strict test conditions but have no substantial problem to be shipped if maintenance and adjustment are provided. Therefore, it is also possible to screen the chips by grouping during the reinspection and to ship the chips based on the screen result.

According to the microstructure inspection method of the present invention, the characteristics of the microstructure can be evaluated by detecting the sound produced from the movable part, and therefore the special test pad intended for inspection use only is not necessary and the test can be readily executed. Furthermore, this inspection method in which devices are evaluated based on the signal characteristics of the detected sound produced by the motion of the movable part can be used for nondestructive inspection to check a devices' possible internal destruction and external destruction, that cannot be found by visual inspection. Therefore, according to the inspection method of the invention, areas of the device to which laser light cannot be irradiated and areas of the device impossible to be inspected unless otherwise destructed can be readily inspected at low cost.

Next description will be made about an inspection of a microstructure having a membrane structure as a chip to be tested.

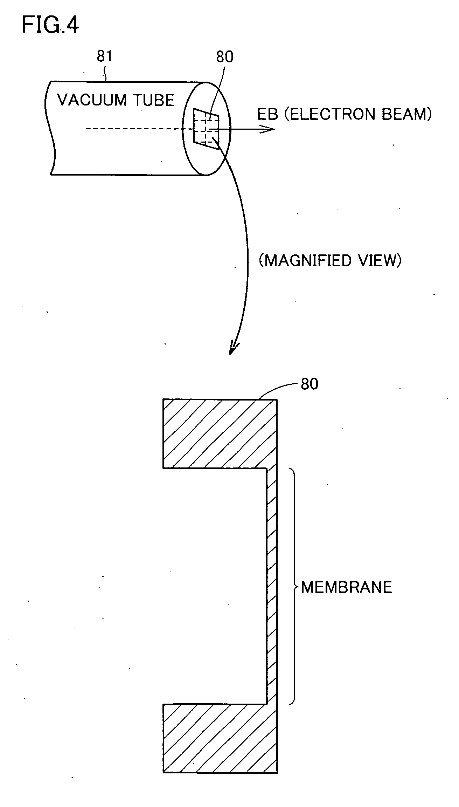

FIG. 4 illustrates a membrane structure used in an irradiation window of an electron beam irradiator. FIG. 4 partially shows an irradiation window 80 from which an electron beam EB passing through a vacuum tube 81 is emitted into the air. The membrane structure in the shape of a thin film is adopted to the window 80 as shown in the enlarged cross sectional structure. Although FIG. 4 merely shows a single layered membrane structure made of a single material, the irradiation window can be formed with a multilayered membrane made of a plurality of materials or with an array of a plurality of membrane structures. Even for machine components having such a movable part, the inspection method according to the embodiment of the invention enables the detection of the presence of damage and cracks and the determination of the quality of the membrane.

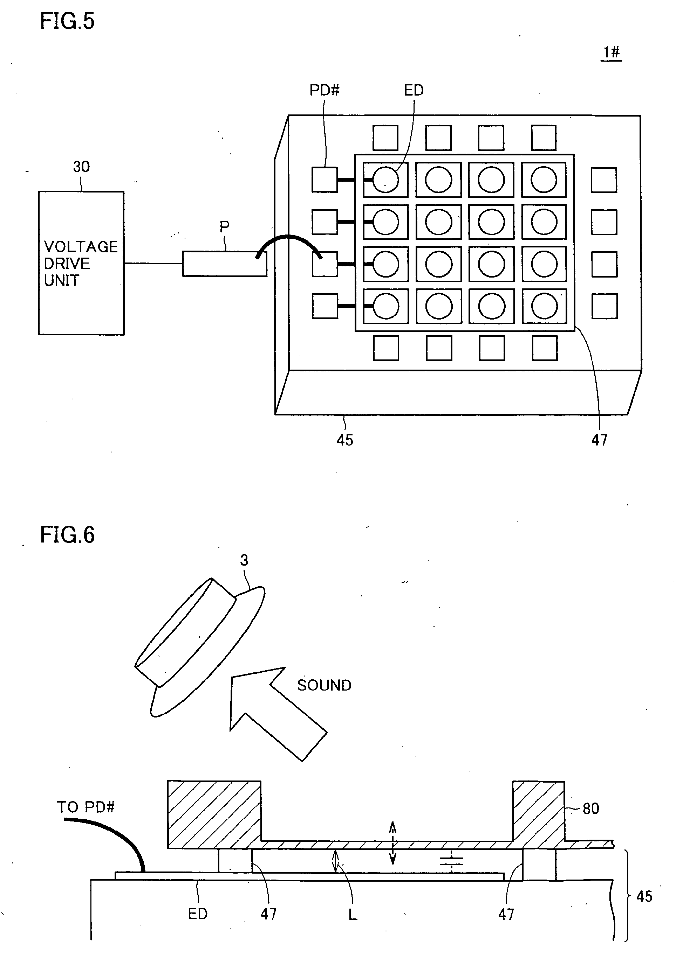

FIG. 5 is a conceptual diagram partially illustrating a microstructure inspection system 1# according to the embodiment of the invention. Specifically, the inspection system 1# according to the embodiment of the invention includes a tester 5 and a measurement jig 45. The tester 5 is the same as the one in FIG. 1 and its detailed description is not reiterated. A voltage drive unit 30 is electrically coupled with pads PD# on the measurement jig 45 through a probe needle P.

FIG. 5 shows the case where a pad PD# is electrically coupled with the probe needle P as an example. A spacer 47 is placed on a surface of the measurement jig 45 so as to prevent electrodes ED from making contact with irradiation windows 80.

FIG. 6 illustrates a detailed description of a measurement jig 45 and an irradiation window 80 of an electron beam irradiator mounted thereon. Referring to FIG. 6, an electrode ED is formed on a surface of the measurement jig 45. In order to secure a predetermined space L between the electrode ED and irradiation window 80, the spacer 47 is provided. As mentioned above, the electrode ED and an external pad PD# are electrically coupled.

The inspection method is executed following the same steps as described in FIG. 3. In short, when a voltage is applied from the voltage drive unit 30 through the probe needle P, the membrane is attracted toward the measurement jig 45 due to electrostatic attraction generated between the membrane and electrode ED. During this periodic attractive motion, the microphone 3 detects a sound output from the device with the membrane structure. Then, the measurement unit 25 measures the detected sound, and the control unit 20 makes a determination.

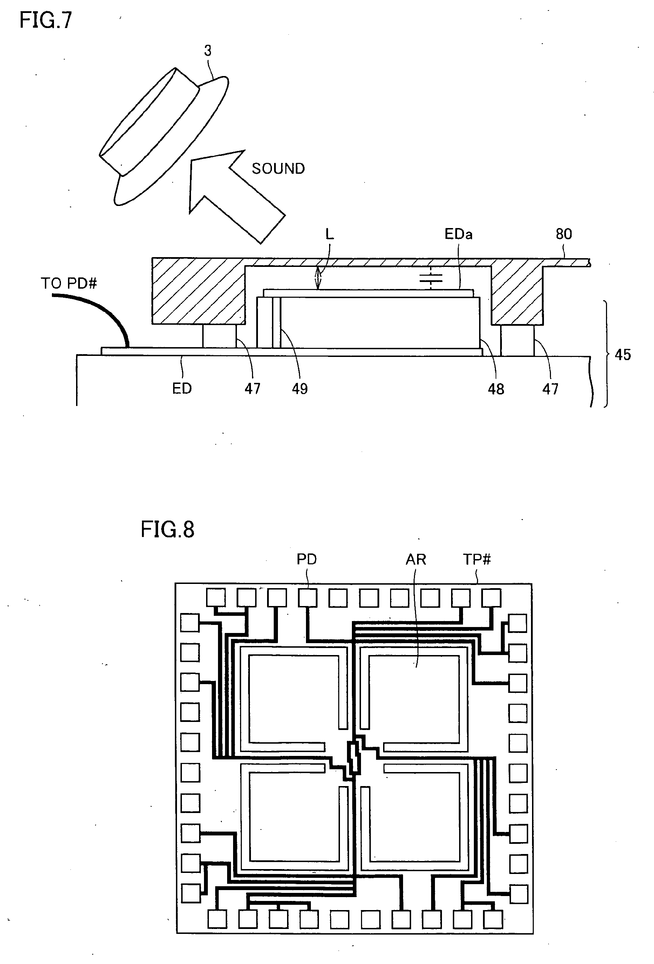

FIG. 7 is another illustration to describe in detail the measurement jig 45 and the irradiation window 80 of an electron beam irradiator mounted thereon. Referring to FIG. 7, as compared with the irradiation window 80 shown in FIG. 6, the different point is that the irradiation window 80 having the membrane structure of FIG. 6 is placed facing down, while the irradiation window 80 having the membrane structure of FIG. 7 is placed facing up. In addition, a spacer 48 and a sub-electrode EDa are mounted on the electrode ED which is electrically coupled with the sub-electrode EDa through a contact hole penetrating the spacer 48. As in the case of FIG. 6, the electrode, that is the sub-electrode EDa, is set so as to have a distance L from the membrane structure. Inspection of a microstructure can be performed in the case of FIG. 7, according to the same steps described in FIG. 6.

Next description will be made about a triaxial acceleration sensor which is another microstructure.

FIG. 8 is an overhead view of a device of the triaxial acceleration sensor. As shown in FIG. 8, a plurality of pads PD are arranged around the periphery of a chip formed on a board. Metal wires are installed to transmit electrical signals to and from the pads PD. In the central part, four masses AR are arranged like a four-leaf clover.

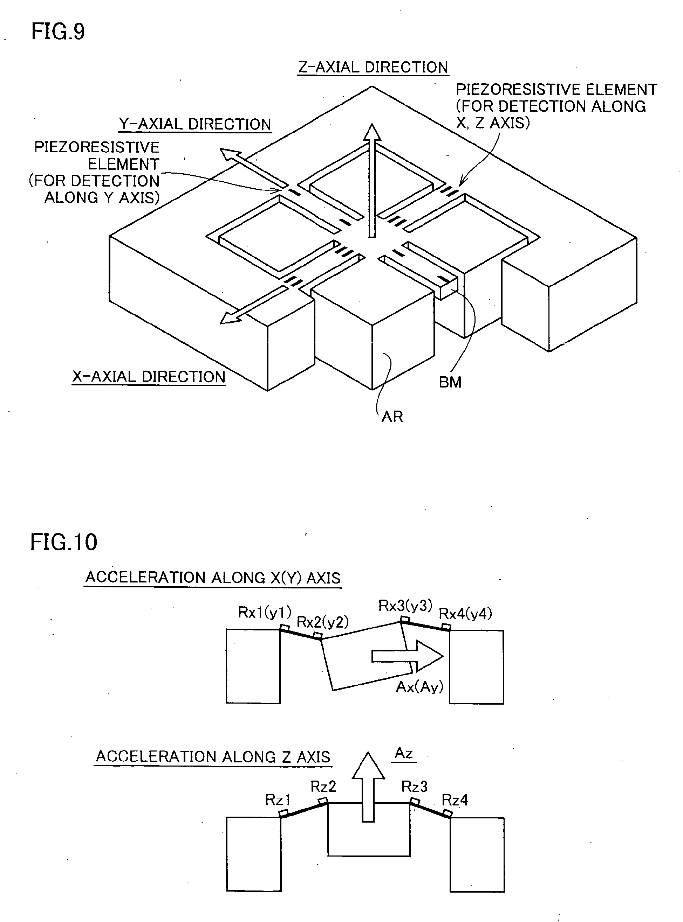

FIG. 9 is a schematic diagram of the triaxial acceleration sensor. Referring to FIG. 9, this triaxial acceleration sensor is a piezoresistive acceleration sensor including piezoresistive elements, which are detecting elements, serving as diffusion resistance. This piezoresistive acceleration sensor has advantages in miniaturization and cost-reduction because of the use of an inexpensive IC process and no desensitization of the resistive elements, which are the detecting elements, caused by their downsizing.

In a concrete configuration, the masses AR in the middle are supported by four beams BM, respectively. The beams BM are formed so as to be orthogonal to each other in the two axial directions X and Y, and four piezoresistive elements are provided for each axis. Four piezoresistive elements for detecting acceleration in the axial direction Z are disposed next to the piezoresistive elements for detecting acceleration in the axial direction X, respectively. The masses AR are linked to the beams BM in the center part and thus take the shape of a four-leaf clover on their top. The adoption of this four-leaf clover-shaped structure allows the masses AR to be larger and the beams to be longer, thereby making it possible to realize a small but high-sensitive acceleration sensor.

The operating principle of this triaxial piezoresistive acceleration sensor is, when the beams BM are deformed by the masses that have received acceleration (inertial force), to detect the acceleration based on a change in the resistance value of the piezoresistive elements formed on a surface of the deformed beams BM. The outputs of this sensor are so set to be taken out from Wheatstone bridges, which will be described later, each independently incorporated in three axes.

FIG. 10 is a conceptual diagram illustrating the masses and deformation of the beams in the case where acceleration is applied in the direction of each axis. As shown in FIG. 10, the piezoresistive element has the property in which its resistance value changes with the applied strain (piezoresistive effect). The resistance value increases with tensile strain, while decreasing with compressive strain. This embodiment indicates, as an example, the piezoresistive elements Rx1 to Rx4 for detecting acceleration in the axial direction X, the piezoresistive elements Ry1 to Ry4 for detecting acceleration in the axial direction Y and the piezoresistive elements Rz1 to Rz4 for detecting acceleration in the axial direction Z.

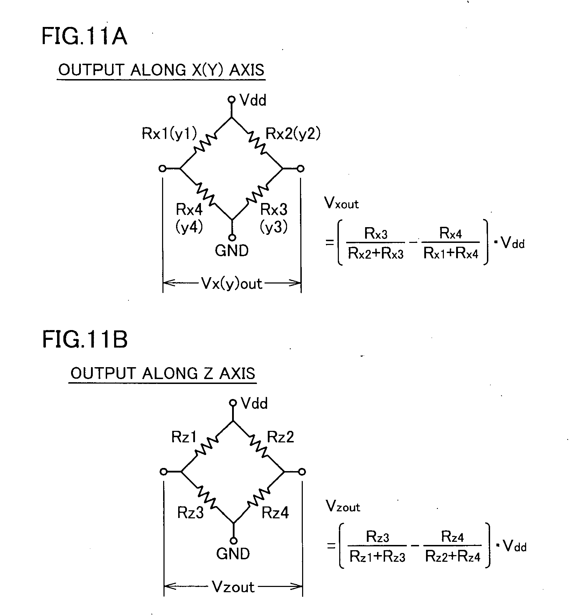

FIG. 11A is a circuit configuration diagram of a Wheatstone bridge for the axis X (Y). The output voltages of the axes X and Y shall be Vxout and Vyout, respectively.

FIG. 11B is a circuit configuration diagram of a Wheatstone bridge for the Z axis. The output voltage of the Z axis is Vzout.

As discussed above, the resistance values of the four piezoresistive elements along each axis change due to the strain applied to the elements. On the basis of the change, for the X axis and Y axis, for example, acceleration components applied to each axis are detected in the Wheatstone bridge circuits as independent, separate output voltages. In order to form the above circuit, metal wires or the like as shown in FIG. 8 are coupled so as to allow the output voltage for each axis to be detected from a predetermined pad.

This triaxial acceleration sensor can also detect the DC component of the acceleration, and therefore can be used as an inclinometer sensor, in other words, an angular velocity sensor for detecting gravitational acceleration.

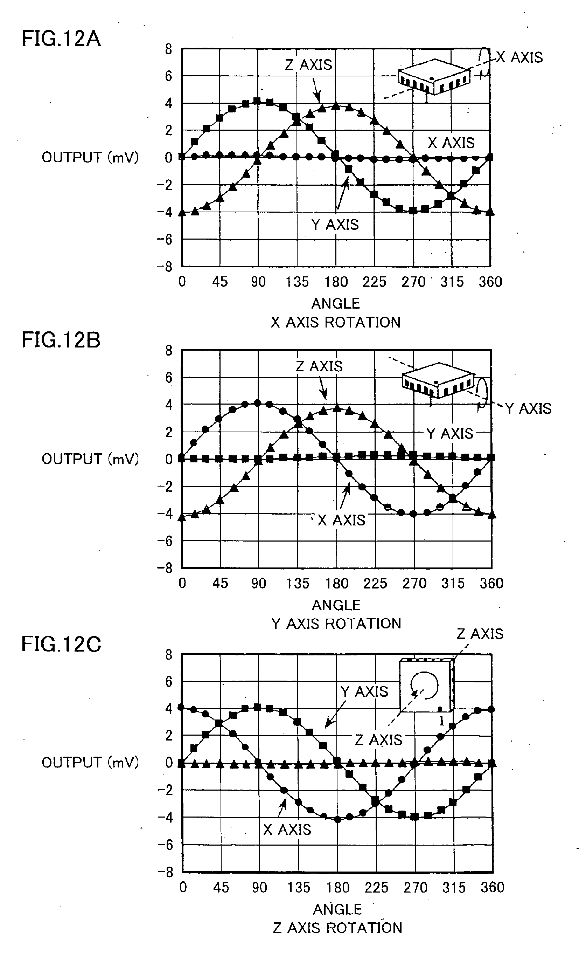

FIGS. 12A, 12B, 12C illustrate the output response relative to inclination angles of the triaxial acceleration sensor. The output responses shown in these drawings were obtained by measuring each bridge output of X, Y, and Z axes while the sensor was being rotated around X, Y, and Z axes, respectively, with the use of a digital voltmeter. The sensor was operated with a low voltage power supply of +5 V. Here, values from which the offsets of the respective axial outputs have been arithmetically subtracted are plotted as the respective measurement points shown in FIGS. 12A, 12B, and 12C.

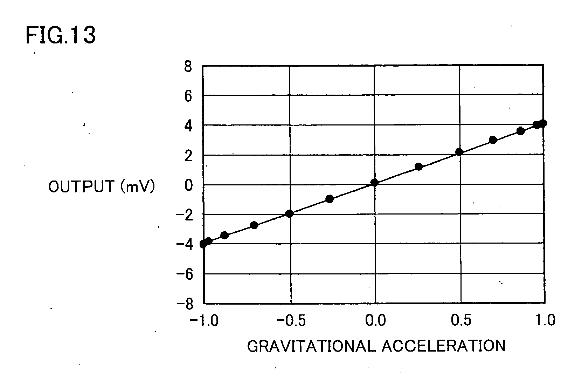

FIG. 13 illustrates the relationship between the gravitational acceleration (input) and sensor output. As shown in FIG. 13, the input/output relationship was obtained by calculating gravitational acceleration components applied to the respective X, Y and Z axes from cosines of the inclination angles of FIGS. 12A, 12B, and 12C and then determining the relationship between the gravitational acceleration (input) and sensor output to evaluate the linearity of the input/output relationship. There thus exists an approximately linear relationship between the acceleration and output voltage.

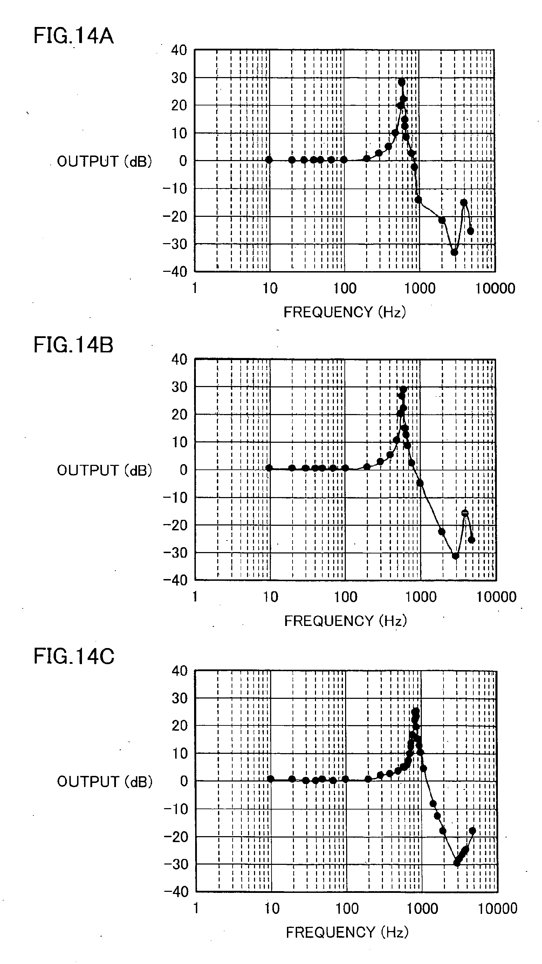

FIGS. 14A, 14B, 14C illustrate the frequency characteristics of the triaxial acceleration sensor. These drawings show, as an example, that the frequency characteristics of the sensor outputs associated with the X, Y, and Z axes are represented by a flat line up to the vicinity of 200 Hz, but resonance occurs at 602 Hz along the X axis, at 600 Hz along the Y axis, and at 883 Hz along the Z axis.

Therefore, based on the frequency characteristics shown in FIGS. 14A, 14B, 14C, the device characteristics can be also evaluated, for example, by determining whether a resonant sound is detected or not in response to the resonant frequency caused by the motion of the triaxial acceleration sensor.

This triaxial acceleration sensor can be inspected in the same scheme taken with the inspection system 1# shown in FIG. 5.

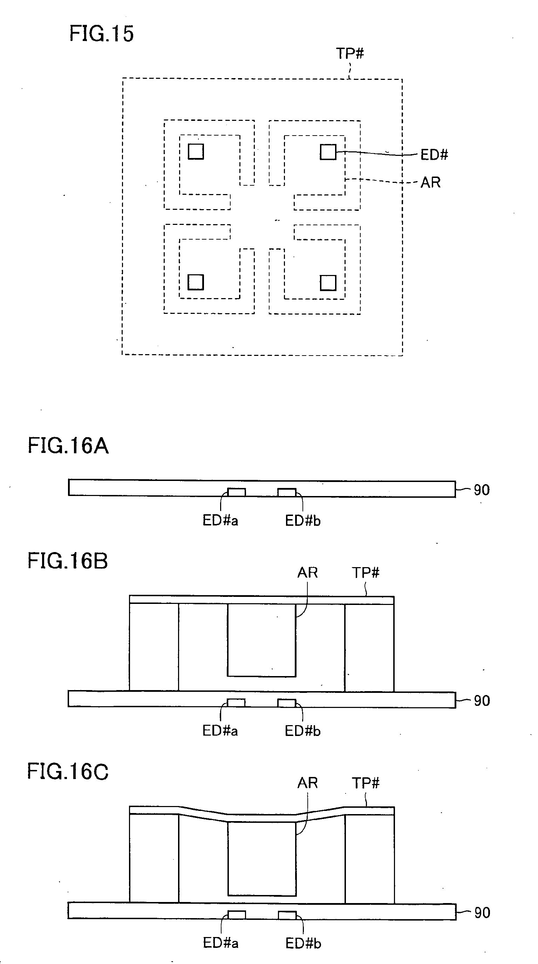

FIG. 15 illustrates a device of the triaxial acceleration sensor provided with a measurement jig thereunder. FIG. 15 indicates electrodes ED# provided in the measurement jig (not shown) on the bottom of the triaxial acceleration sensor. Specifically, an electrode ED# is provided for each mass AR. These electrodes ED# are not illustrated but electrically coupled with the voltage drive unit 30 of the tester 5 through the probe needle or the like in the same manner shown in FIG. 5.

FIGS. 16A, 16B, 16C are schematic side views of the device in the test of the triaxial acceleration sensor.

FIG. 16A shows electrodes ED#a and ED#b embedded in the measurement jig 90. The electrodes ED#a and ED#b are electrically coupled with the voltage drive unit 30 of the tester 5 as mentioned above and applied with a predetermined voltage from the voltage drive unit 30.

FIG. 16B illustrates a chip TP# of the triaxial acceleration sensor, in the stationary state, mounted on the measurement jig 90. As shown in FIG. 16B, the electrodes ED#a and ED#b are arranged so as to be positioned in an area below the mass AR.

FIG. 16C illustrates the movement of the triaxial acceleration sensor mounted on the measurement jig 90 when voltage is applied. As shown in FIG. 16C, when voltage is applied to the electrodes ED#a and ED#b, the mass AR is attracted toward the electrodes due to the electrostatic attraction. The inspection is performed according to the same steps shown in FIG. 3. Specifically, when the voltage is applied from the voltage drive unit 30 to the electrodes ED#, the mass AR is attracted toward the measurement jig 90 due to the electrostatic attraction between the electrodes ED# and mass AR. By periodically producing this attractive action, a sound output from the mass AR is detected by the microphone 3. Then, the measurement unit 25 takes a measurement of the detected sound and the control unit 20 makes a determination.

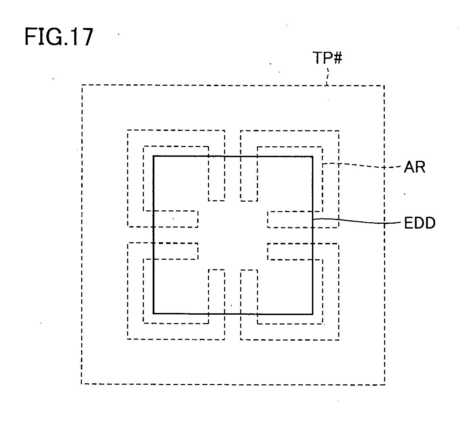

FIG. 17 illustrates the device of the triaxial acceleration sensor provided with another measurement jig thereunder. As shown in FIG. 17, there is no need to provide an electrode for each mass AR. Thus, the inspection can be executed with a single electrode EDD according to the same steps.

Although a triaxial piezoresistive acceleration sensor is used as an exemplary model, triaxial acceleration sensors for capacitance detection can be inspected in the same manner. In the case of the triaxial capacitive acceleration sensors, for example, a test signal to move the masses is applied to an electrode for detecting the capacitance. With the motion of the masses in response to the test signal, the same inspection as described above can be executed to make a determination. In this case, the above-mentioned electrodes embedded in the measurement jig are not necessary, thereby achieving simpler design of the tester and so on.

The environment for detecting sounds is assumed to be in the atmosphere, however, the present invention is not limited to this. The inspection can be executed in a liquid that reduces sound attenuation, thereby enabling high-sensitive detection of the sound and thus high-precision inspection.

It should be understood that the embodiments disclosed herein are to be taken as examples and are not limited in every respect. The scope of the present invention is defined not by the above described embodiments but by the following scope of claims. All changes that fall within meets and bounds of the claims, or equivalence of such meets and bounds are intended to be embraced by the claims.

### INDUSTRIAL APPLICABILITY

The present invention can be advantageously used for microstructure inspection apparatuses and methods.

## Claims

1. A microstructure inspection apparatus for evaluating the characteristics of a microstructure with a movable part, comprising:
electric drive means for providing motion to said movable part of the microstructure; and
characteristic evaluation means for detecting a sound produced by the motion of said movable part of the microstructure provided by said drive means and for evaluating the characteristics of said microstructure based on the detection results.

2. The microstructure inspection apparatus according to claim 1, wherein
a plurality of said microstructures are arranged in an array form on a base.

3. The microstructure inspection apparatus according to claim 1, wherein
said characteristic evaluation means comprises:
measurement means for detecting a sound produced in response to the motion of said movable part of the microstructure; and
determination means for evaluating the characteristics of said microstructure based on a comparison between the signal characteristics of the sound detected by said measurement means and the signal characteristics of a sound serving as a predetermined threshold.

4. The microstructure inspection apparatus according to claim 3, wherein
said measurement means detects the frequency characteristics of sounds, and
said determination means evaluates the characteristics of said microstructure by comparing the frequency characteristics of a sound detected by said measurement means and the frequency characteristics of a sound serving as a predetermined threshold.

5. The microstructure inspection apparatus according to claim 3, wherein
said measurement means detects the amplitude of sounds, and
said determination means evaluates the characteristics of said microstructure by comparing the amplitude of a sound detected by said measurement means and the amplitude of a sound serving as a predetermined threshold.

6. The microstructure inspection apparatus according to claim 3, wherein
said measurement means detects the phase characteristics of sounds, and
said determination means evaluates the characteristics of said microstructure by comparing the phase characteristics of a sound detected by said measurement means and the phase characteristics of a sound serving as a predetermined threshold.

7. The microstructure inspection apparatus according to claim 1, wherein
said microstructure is at least one device selected from the group consisting of a switch, an acceleration sensor, an angular velocity sensor, a pressure sensor and a microphone.

8. The microstructure inspection apparatus according to claim 7, wherein
said acceleration sensor is a multiaxial acceleration sensor, and
said angular velocity sensor is a multiaxial angular velocity sensor.

9. A microstructure inspection method comprising the steps of:
providing motion to a movable part of a microstructure by using electric means;
detecting a sound produced by the motion of said movable part of the microstructure;
evaluating the characteristics of said microstructure based on the detection results of said sound.

10. The microstructure inspection method according to claim 9, wherein
said characteristic evaluation step includes a step of performing comparison between the signal characteristics of the detected sound and the signal characteristics of a sound serving as a predetermined threshold.

11. The microstructure inspection method according to claim 9, wherein
said sound detection step includes a step of performing detection of the frequency characteristics of sounds, and
said characteristic evaluation step includes a step of performing comparison between the frequency characteristics of the detected sound and the frequency characteristics of a sound serving as a predetermined threshold.

12. The microstructure inspection method according to claim 9, wherein
said sound detection step includes a step of performing detection of the amplitude of sounds, and
said characteristic evaluation step includes a step of performing comparison between the amplitude of the detected sound and the amplitude of a sound serving as a predetermined threshold.

13. The microstructure inspection method according to claim 9, wherein
said sound detection step includes a step of performing detection of the phase characteristics of sounds, and
said characteristic evaluation step includes a step of performing comparison between the phase characteristics of the detected sound and the phase characteristics of a sound serving as a predetermined threshold.
